**Europäisches Patentamt**

**European Patent Office**

**Office européen des brevets**

(11) Publication number: **0 157 028**

**B1**

## EUROPEAN PATENT SPECIFICATION

(45) Date of publication of patent specification: **25.10.89**

(51) Int. Cl.⁴: **G 01 R 31/28**

(21) Application number: **84302330.0**

(22) Date of filing: **05.04.84**

(54) **Programmable tester.**

(43) Date of publication of application:
**09.10.85 Bulletin 85/41**

(45) Publication of the grant of the patent:
**· 25.10.89 Bulletin 89/43**

(84) Designated Contracting States:
**DE FR GB IT**

(56) References cited:
**EP-A-0 053 561**
**EP-A-0 067 496**
**US-A-4 292 586**

(73) Proprietor: **GRUMMAN AEROSPACE CORPORATION**
**South Oyster Bay Road**
**Bethpage, NY 11714 (US)**

(72) Inventor: **Andreano, Richard J.**
**13 Oakledge Drive**
**East Northport New York 11731 (US)**
Inventor: **Zourides, Victor G.**
**20 Millet Street**
**Dix Hills New York (US)**

(74) Representative: **Prutton, Roger et al**
**MARKS & CLERK Alpha Tower Suffolk Street**
**Queensway**
**Birmingham B1 1TT (GB)**

## Description

This invention relates to the field of test equipment, and more particularly to a programmable tester capable of testing automatically a variety of electronic units.

With the introduction into the marketplace of sophisticated electronic equipment consisting of analog, digital and hybrid circuitry, there has developed a growing need for a portable tester capable of testing automatically this equipment. This need for a portable tester is further enhanced when one recognizes that much of the electronic equipment to be tested is itself portable, i.e., it is quite frequently moved and situated at different locations, or is part of an operating environment which is portable, such as an aircraft.

A number of systems to measure the response of a unit under test (UUT) to preselected applied stimuli are known in the art. A primary purpose of the known systems has been to determine whether the unit under test is operating, or is operable, in accordance with predefined performance specifications. One of the significant disadvantages of the known systems of this type is that to a large extent they have been hard wired and specially configured to test only one or at most a few similar functional UUT's. Accordingly, it has been necessary to maintain a relatively large inventory of such expensive systems where large numbers of unrelated UUT's are to be tested.

One approach which attempts to solve the problems inherent in some of the known systems is described in United States Patent US—A—3,764,995. However, the disclosed system has several limitations and drawbacks associated therewith. In particular, its cost and size precludes cost-effective application in many areas of interest. Moreover, it also requires a large, very complex and costly interface device to adapt the unit under test to the tester.

European Patent Publication No. EP—A—0067496 discloses a programmable test apparatus comprising connecting means for receiving interface means configured to adapt a unit under test having digital, analog or hybrid electronics to said test apparatus; microprocessor type system bus means; microcomputer means operatively connected to said microprocessor type system bus means and including means for executing a test program for testing the operation of said unit under test; memory means associated with said microcomputer means operatively connected to said microprocessor type system bus means; microprocessor control means operatively connected to said microprocessor type system bus means and including means for loading from an external software station said test program into said microcomputer memory means; programmable stimulus generating means operatively connected via said microprocessor type system bus means to said microprocessor control means and said microcomputer means; programmable response measuring means operatively connected via said microprocessor type system bus means to said microprocessor control means and said microcomputer means; and programmable switching means for selectively connecting said stimulus generating means and said response measuring means via said interface means to said unit under test, said switching means responsive to and operatively connected via a switching control bus means to said microprocessor control means.

However, such testing means is unsatisfactory in respect to the means and operations required within the testing means itself for operating a test program written in a high level language such as ATLAS and the present invention seeks to overcome these difficulties in a simple and economical manner.

Whilst EP—A—0053561 discloses a test apparatus having an alpha-numerical display and a keyboard, it does not address the difficulties referred to above.

The present invention includes, in addition to the features referred to above in relation to EP—A—0067496, an alpha-numeric display and a keyboard. The memory means includes non-volatile memory containing an interpreter program, for interpreting into microprocessor instructions a test program loaded from non-volatile memory in the interface means. This test program is stored in a compact interpretive code format which is interpreted by the interpreter program to control the carrying out of tests determined by the test program.

Thus the test apparatus of the invention does not require any ability to deal with test programs written in a high level language.

Serving to illustrate an exemplary embodiment of the invention are the drawings of which:

Figure 1 is a functional block diagram of the programmable tester, in accordance with the present invention;

Figure 2A is a functional block diagram of programmable microprocessor control subsystem 3;

Figure 2B illustrates in more detail the relay control portion of the microprocessor control subsystem 3;

Figure 3 is a functional block diagram of programmable precision voltage source 4;

Figure 5 is a functional block diagram of programmable function generator 5;

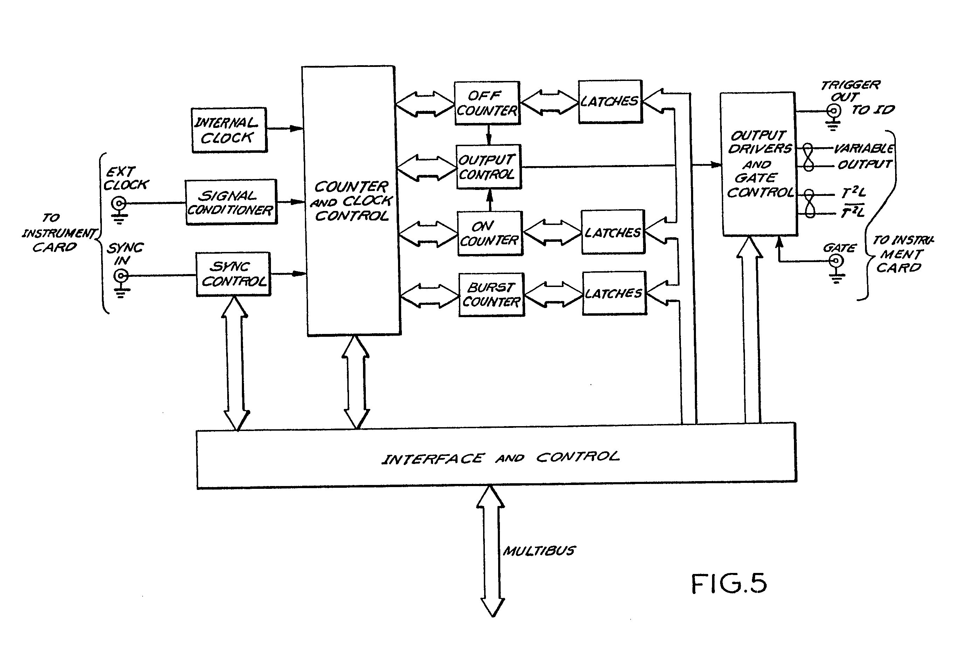

Figure 5 is a functional block diagram of programmable pulse generator 6;

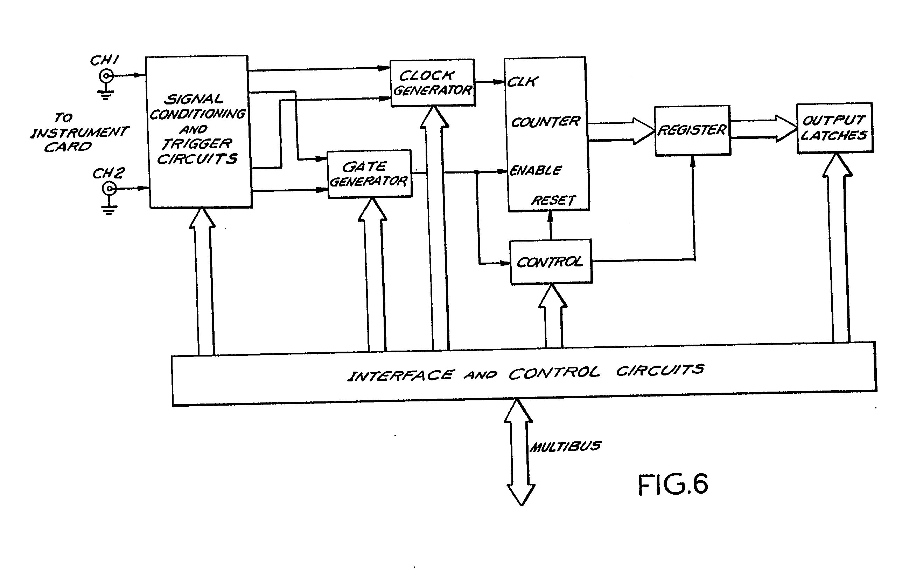

Figure 6 is a functional block diagram of programmable counter/timer 7;

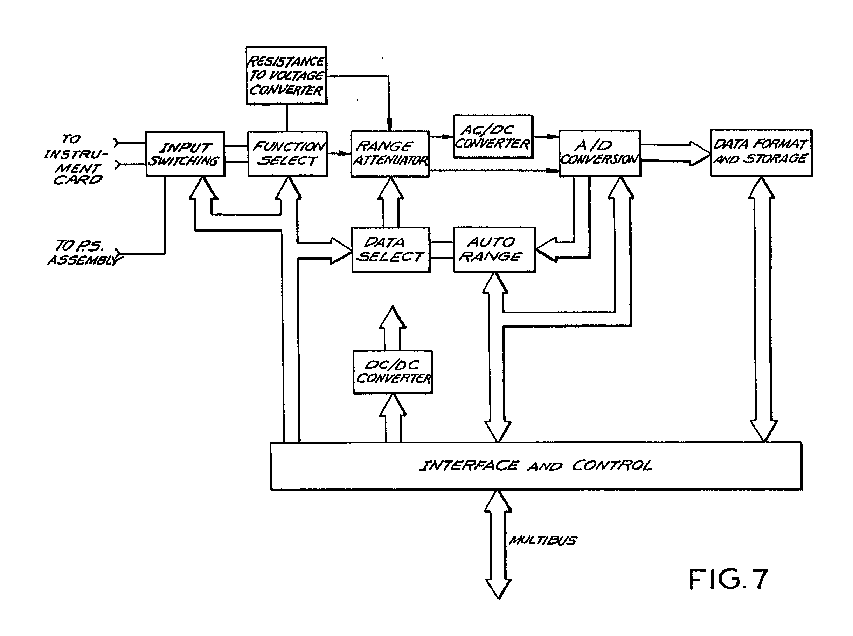

Figure 7 is a functional block diagram of programmable digital multimeter 8;

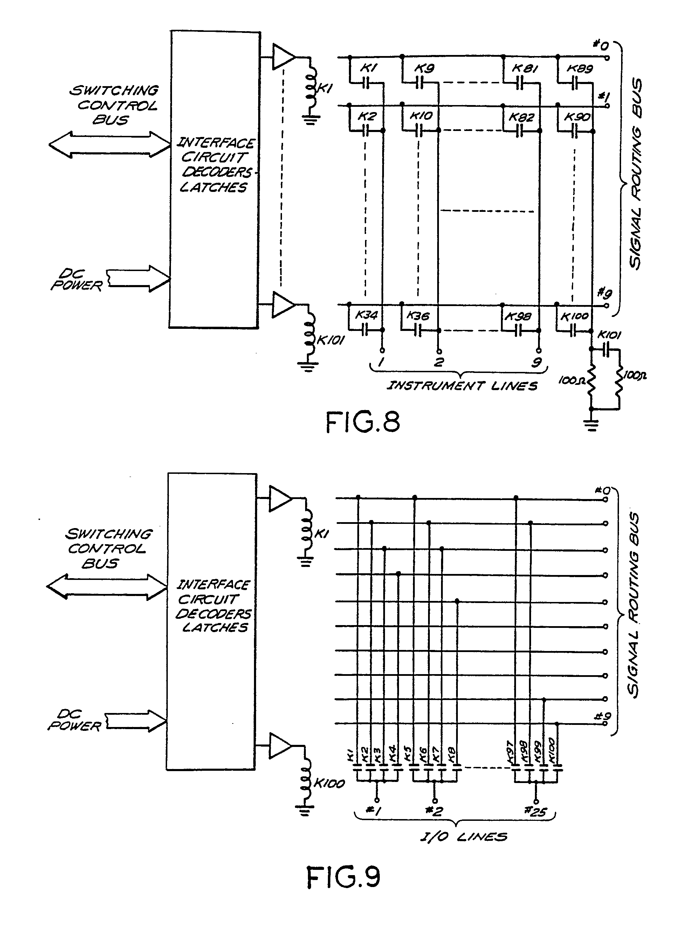

Figure 8 is a functional block diagram of programmable instrument switching network 9;

Figure 9 is a functional block diagram of programmable I/O switching network 11;

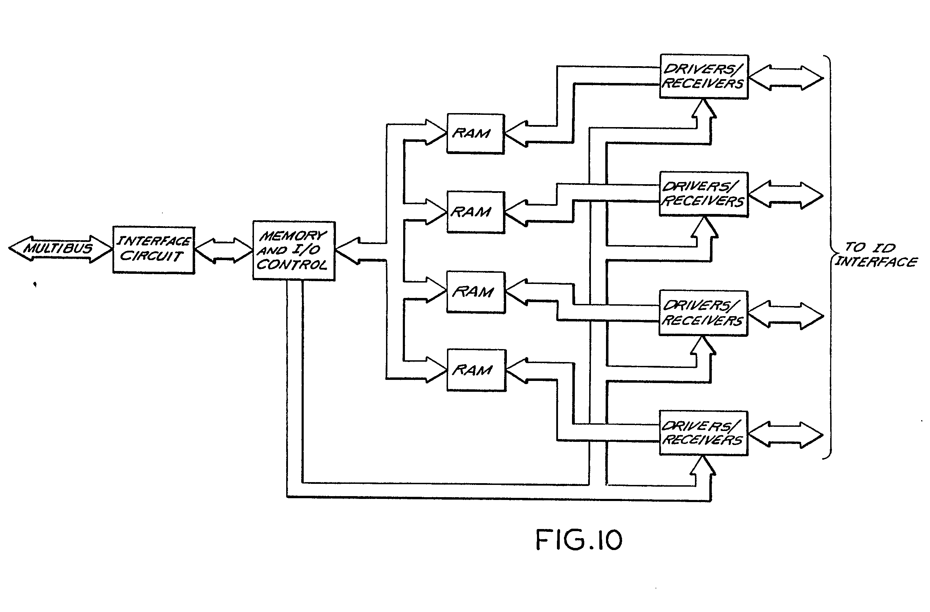

Figure 10 is a functional block diagram of programmable digital signal generator 15;

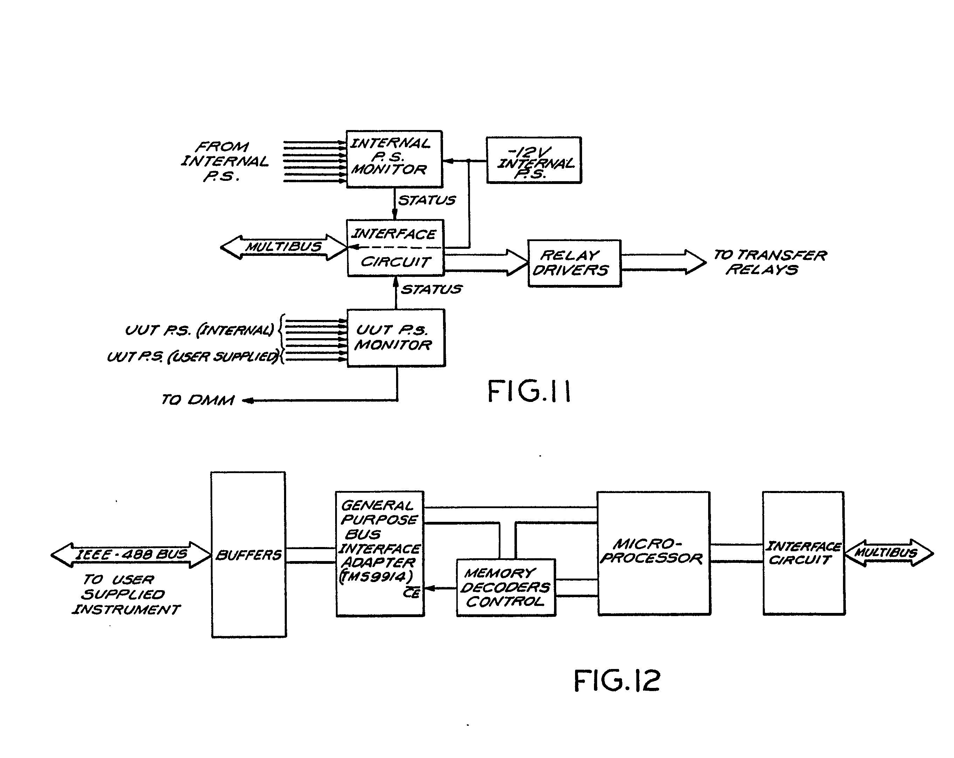

Figure 11 is a functional block diagram of power supply control network 18; and

Figure 12 is a functional block diagram of optional IEEE-488 interface network 22.

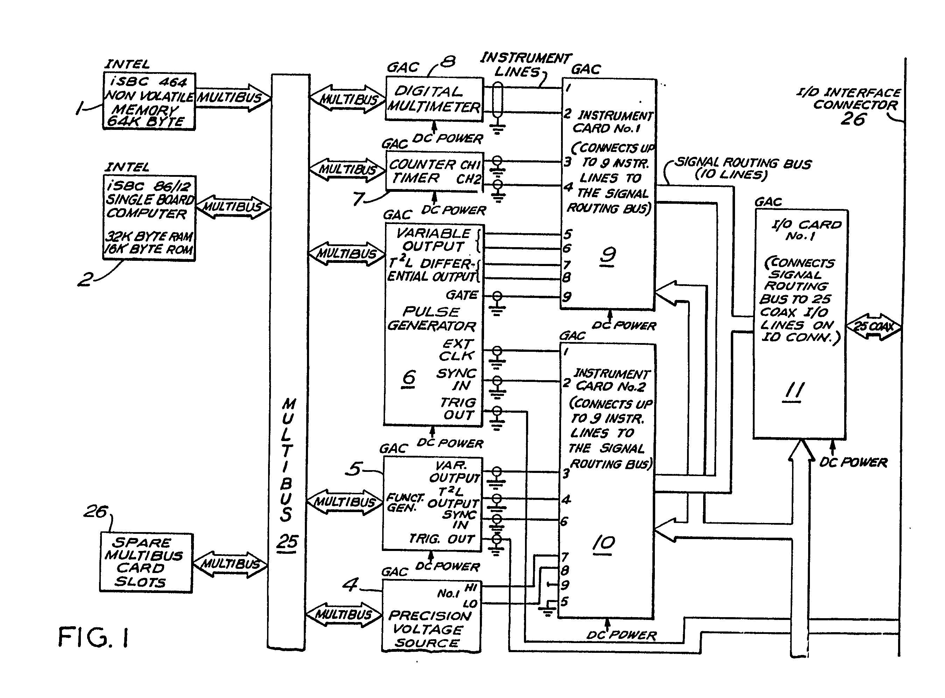

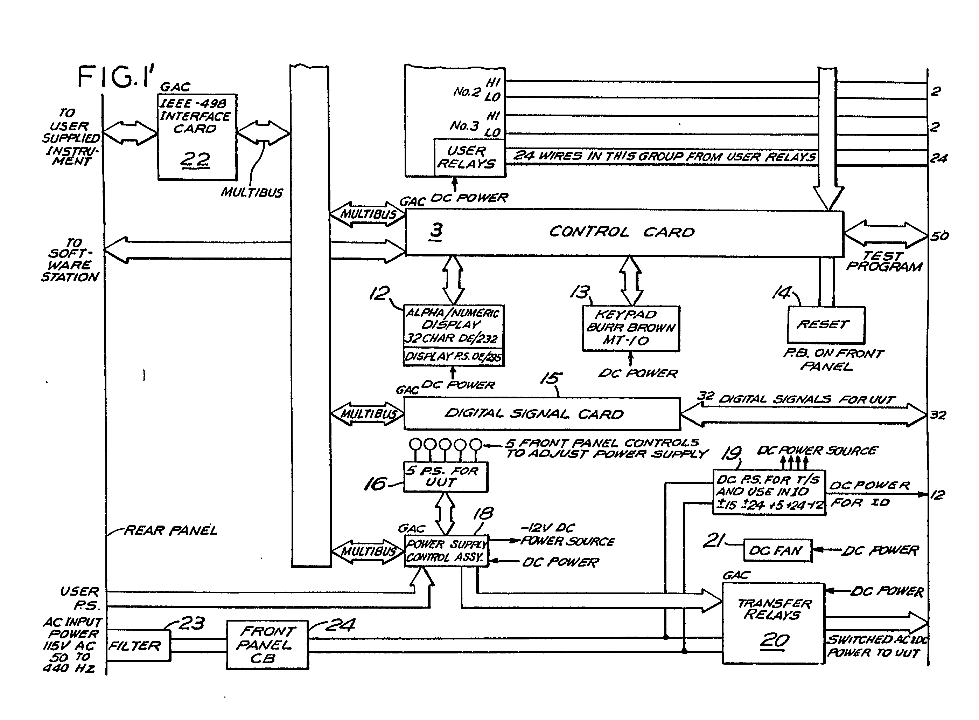

Referring to Figure 1, a block diagram of the programmable tester, in accordance with the present invention, is illustrated. As shown therein, the tester consists of a number of functional units, each of which is described below.

The non-volatile memory 1 which may consist, for example, of an Intel iSBC 464, holds up to 64K bytes of EPROM/ROM which contain an interpreter and instrument drivers. The interpreter interprets the interpretive code (IC) program which is loaded into the RAM located on microcomputer 2, which may consist, for example, of an Intel iSBC 86/12 single board computer, and passes to the instrument drivers the parameters and commands that they require.

Microcomputer 2 contains 32K bytes of RAM and can hold up to 16K bytes of EPROM/ROM. The RAM is divided into two functional areas wherein 16K bytes of RAM are reserved for holding the IC form of the test program when it is read from the Interface Device (ID) (not shown). The remaining portion of the RAM is used for scratchpad, interrupt addresses, stack, etc. The EPROM/ROM contains a monitor, an executive, a self test program, interrupt handling routines, and a program for reading the IC test program from the ID, or software station (not shown), into the RAM, a program for controlling the alpha-numeric (A/N) display 12, and a program for reading and writing to the keyboard 13.

The instrument drivers accept parameters and commands from the interpreter and send parameters and commands to the instruments. The instrument drivers can also read information back from the instruments and pass the information back to microcomputer 2 for use by the test program. Communication between non-volatile memory 1, microcomputer 2 and the instrument is via the system bus 25 which may consist, for example, of an Intel Multibus.

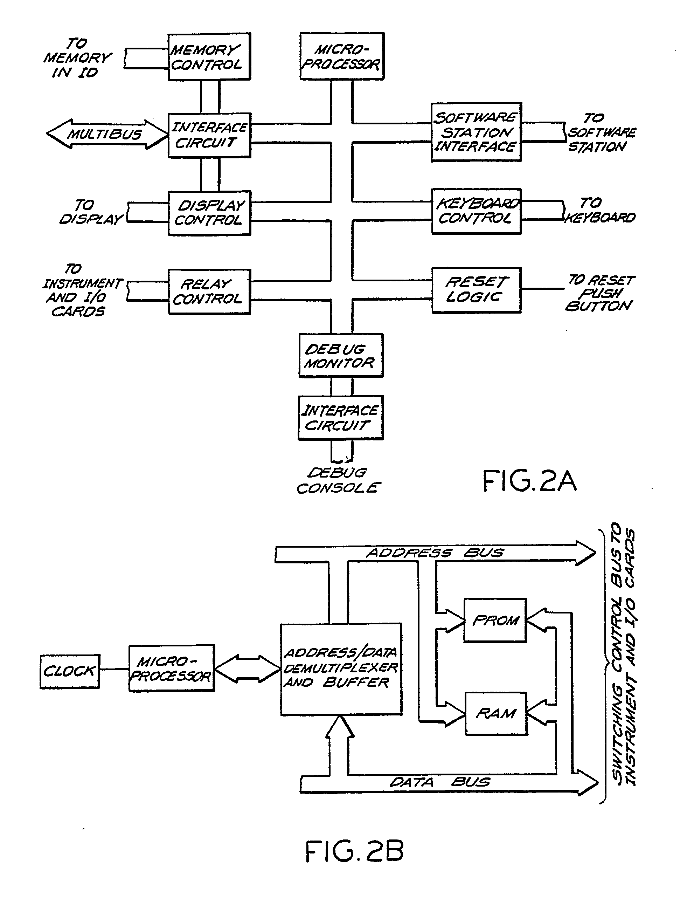

A functional block diagram of the programmable microprocessor control subsystem 3 and a block diagram of the relay control portion thereof are illustrated in Figures 2A and 2B, respectively. The microprocessor control subsystem performs several functions. In particular, it provides an interface between a software station (not shown) and the system bus 25. This enables loading test programs which are under development directly from the software station into the RAM on the microcomputer 2 without the need for non-volatile memory in the ID which is the normal source of the test program. It provides an interface between the keyboard 13 and microcomputer 2 allowing the operator to communicate with and control the tester via the keyboard. The microprocessor control subsystem also provides an interface between microcomputer 2 and the IC test program in the ID. This provides the electrical path and buffering necessary to load the IC test program from the non-volatile memory in the ID into the RAM on microcomputer 2. Furthermore, the microprocessor control subsystem provides the interface between microprocessor 2 and the A/N display 12. And finally, the microprocessor control subsystem contains the microprocessor and program necessary to determine the proper relay paths in the programmable switching subsystem to close in order to connect an instrument to the proper I/O pin from the parameter information passed to it by the switching circuit instrument driver. The operational details thereof are described in U.S. Patent Number 4,300,207, granted on November 10, 1981, to Donald J. Eivers and Eddie J. Kovacs, entitled "Multiple Matrix Switching System", and assigned to the assignee of the present invention.

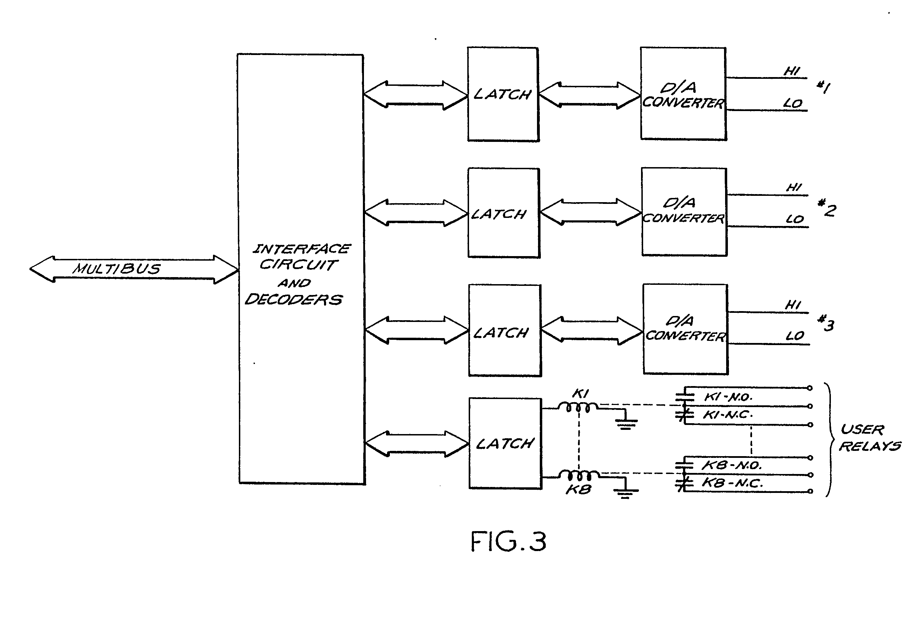

A programmable stimulus subsystem including one or more of the following units (a) programmable voltage source 4, (b) programmable function generator 5, and (c) programmable pulse generator 6 provides desired stimuli to the unit under test. A functional block diagram of programmable precision voltage source 4 is illustrated in Figure 3. The programmable precision voltage source contains three precision voltage sources and eight SPDT relays. One precision voltage source is connected to the programmable switching network 10 and can be routed to any one or more of the I/O pins associated with programmable I/O network 11. The remaining two precision voltage sources are routed directly to the ID interface connector 26. The N.O., N.C. and common of each of the eight relays are brought to the ID interface connector 26. The 3 precision DC voltage sources and the 8 relays are all under program control and are independent of one another. Commands from its instrument driver to this instrument pass over the system bus 25.

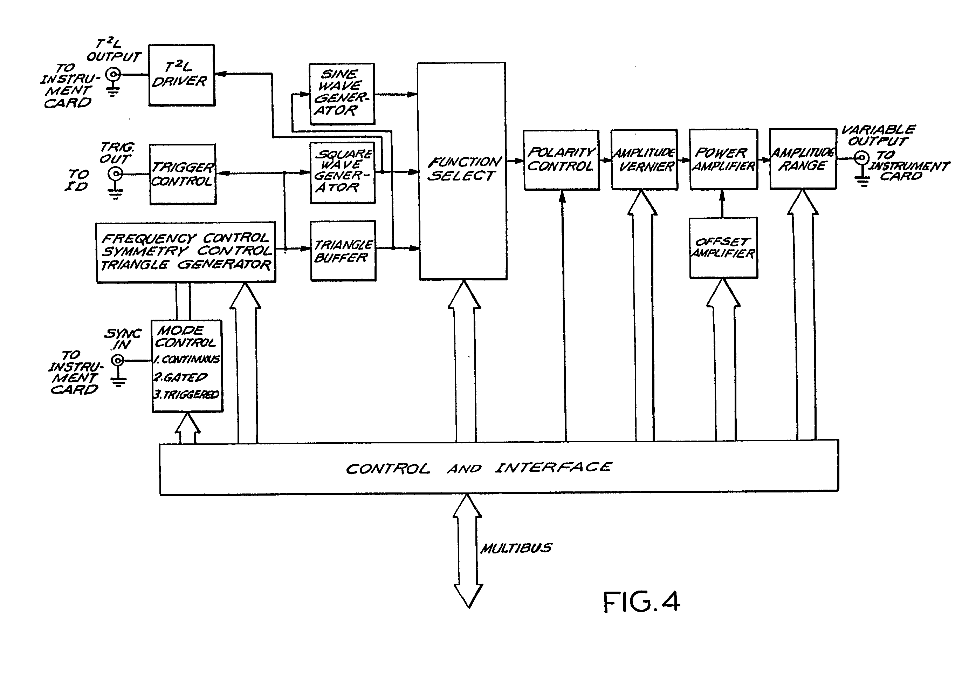

A functional block diagram of programmable function generator 5 is illustrated in Figure 4. The programmable function generator provides a variety of UUT test stimuli including triangle, sine wave, and pulse signals from its variable amplitude output and TTL compatible signals from its TTL output. The programmable function generator provides a trigger output signal and can be synchronized from an external source. The amplitude, frequency, selection of sync source, and output function (i.e., triangle, sine wave, pulse) are all under program control. Parameters and commands are sent to the programmable function generator from its instrument driver via the system bus 25.

A functional block diagram of programmable pulse generator 6 is illustrated in Figure 5. The programmable pulse generator also provides a variety of UUT test stimuli. It has two main outputs, one is variable in amplitude, the other is a differential TTL compatible output. The delay time, on time, and off time of the two outputs are programmable. The amplitude of the variable output is programmable. The programmable pulse generator can be run from an external clock under program control. It has 3 control signals: Gate and Sync inputs which can be selected under program control, and trigger output. Parameters and commands are sent to the programm-

able pulse generator from its instrument driver via the system bus 25.

A programmable response measuring subsystem including either or both of the following units (a) programmable counter/timer 7 and (b) programmable digital multimeter 8 measures specified output parameters of the unit under test. A functional block diagram of programmable counter/timer 7 is illustrated in Figure 6. The operational details thereof are described in a copending U.S. application of Albert A. Star and John M. Weick, entitled "Programmable Signal Analyser", filed September 8, 1981, bearing Serial Number 300,254 (EP—A—0 074 235) and assigned to the assignee of the present invention. The programmable counter/timer measures specified UUT output parameters. It has two inputs CH1 and CH2, CH1 is used to measure frequency, counts, and pulse widths. CH1 and CH2 are used together to measure time intervals between two events. The mode of operation (i.e., frequency, count, pulse width, time interval range, and input threshold level are all programmable). Parameters and commands are sent to the programmable counter/timer and data is read back from the programmable counter/timer to its instrument driver via the system bus 25.

A block diagram of programmable digital multimeter 8 is illustrated in Figure 7. The operational details thereof are described in the aforementioned application of Star and Weick. The programmable digital multimeter also measures specified UUT output parameters. It is capable of measuring DC volts, AC volts, and ohms. The mode, i.e., DC volts, AC volts, ohms, and ranges within each mode are all programmable. Parameters and commands are sent to the programmable digital multimeter and data is read back from the digital multimeter to its instrument driver via the system bus 25.

The programmable switching subsystem including programmable instrument switching networks 9, 10 and programmable I/O network 11 selectively connects the unit under test to the stimulus and response measuring subsystems via the ID. A block diagram of programmable instrument switching network 9 is illustrated in Figure 8. The operational details thereof are described in the aforementioned U.S. patent of Eivers and Kovacs. The programmable instrument switching network has mounted on it the latches, relay drivers, and relays which connect the instrument lines to the signal routing bus. Relay commands and relay status are sent between the programmable instrument switching network and its instrument driver via the system bus 25. Programmable instrument switching network 10 is identical to programmable network 9.

A block diagram of programmable I/O network 11 is illustrated in Figure 9. The operational details thereof are described in the aforementioned U.S. patent of Eivers and Kovacs. The programmable I/O network has mounted on it the latches, relay driver, and relays which connect the signal routing bus to the coax I/O lines which go to the ID interface connector 26. Relay commands and status are sent between the programmable I/O network and its driver via the system bus 25.

Communication between the programmable microprocessor control system 3 and the various units of the programmable switching subsystem is via a switching control bus.

Alpha-numeric display 12 is a standard 32 character display, such as, for example, the Digital Electronics DE/232. Alphanumeric display 12 operates in two basic modes; (1) under control of the ATLAS programmer; and (2) under control of the executive program. When operated under control of the ATLAS programmer, the programmer can use display 12 as he chooses to aid the operator in running the specific test program. The programmer can, for example, display the value of a digital multimeter reading or he can inform the operator that an adjustment must be made on the UUT. When operated under control of the executive program, the executive program uses display 12 to pass information to the operator concerning matters other than a specific ATLAS test program. For example, the operator is informed of the results of Self Test and is given cues to install the ID and UUT prior to beginning an ATLAS test program.

The interface which enables communication between the microcomputer 2 and the display 12 is located in the programmable microprocessor control subsystem 3. Data is passed between microcomputer 2 and microprocessor control subsystem 3 via the system bus 25. Data is passed between microprocessor control subsystem 3 and display 12 via a dedicated bus.

The keyboard 13 is a conventional model, such as, for example, the Burr Brown MT-25. Keyboard 13 contains the hexidicimal numbers 0 through F, a decimal, a dash, clear (CL). Input (IN), and seven special function keys (ST, SS, EW, FLT, a comma, LOAD, GO). The seven special function keys are utilized as follows:

ST: Invokes the Single Test Mode. In this mode the test halts after each change in ATLAS test number. To continue, depress the comma key.

SS: Invokes the Single Step Mode. In this mode, the test halts after a change in either the ATLAS test number or the ATLAS step number. To continue, depress the comma key.

,: Used as a delimiter and as the command to continue when used with ST, SS, GO, EW.

FLT: Converts hexidecimal or decimal data to 32 bit floating point representation which is used to represent the numbers in an IC program. This feature is provided to aid the operator in making changes to, or writing a new IC program.

LOAD: Invokes the program which loads the IC test program stored in the ID into the tester RAM on microcomputer 2. The actual command is load i where i is a single digit hexidecimal integer. A special command, Load AA, is used to load programs under development directly from the software station (not shown) to the RAM on microcomputer 2.

EW: Invokes the Examine Word Mode. Ew aaaa, IN: This sequence of keystrokes will cause the tester to display the data contents of address aaaa on the keyboard display. Note that aaaa represents four hexidecimal digits. Four possible actions are available to the operator at this time.

i. IN terminates EW mode.

ii, IN results in display of data at at next address.

iii dddd, IN results in change of data to dddd at present address.

iv dddd . IN results in change of data to dddd at present address and termination of EW mode.

GO: Used to start running the test program. Three different methods are available.

i. GO . IN begins running test program starting at first test of program.

ii GO aaaaaa . IN begins running test program starting at test number aaaaaa.

iii. GO aaaaaa, IN bbbbbb, IN cccccc, IN dddddd . IN begins running test program starting at aaaaaa with breakpoints at bbbbbb, cccccc, dddddd. Breakpoints bbbbbb and/or cccccc are optional.

CL is the clear key to delete an incorrect entry. The interface which enables communication between the microcomputer 2 and the keyboard 13 is located in the programmable microprocessor control subsystem 3. Data is passed between microcomputer 2 and microprocessor control subsystem 3 via the system bus 25. Data is passed between microprocessor control subsystem 3 and keyboard 13 via a dedicated bus.

A conventional pushbutton 14 is used to reset the tester.

A block diagram of the programmable digital signal generator 15 is illustrated in Figure 10. The programmable digital signal generator contains 32 digital signal lines arranged in four groups of eight lines each. Each group can be independently programmed as an output group or an input group. Commands and data pass between the programmable digital signal generator and its instrument driver via the system bus 25. The input and outputs of the programmable digital signal generator are TTL compatible.

As configured, the programmable tester includes five separate adjustable DC power supplies 16 which are used to provide power to the UUT. The power supplies 16 are stock commercial parts available from, for example, ACOPIAN. These power supplies are adjusted manually. Front panel knobs 17 are used to manually set the voltages of power supplies 16.

A block diagram of the power supply control network 18 is illustrated in Figure 11. As shown therein, it has the following circuits mounted on it.

(a) −12V P.S.

(b) UUT P.S. Monitor: When each UUT power supply is adjusted this circuit connects the output of the power supply to the programmable digital multimeter 8 which provides a digital representation of the power supply output voltage to microcomputer 2 which in turn causes the voltage to be displayed on the alphanumeric display 12. In addition, the information from this circuit is used to prevent power supply voltages from being applied to the UUT until all are within tolerance.

(c) Internal P.S. Monitor: This circuit monitors the DC voltages required for operation of the programmable tester. The status of the monitor is checked during Self Test.

(d) Transfer Relay Drivers: These are programmable relay drivers associated with the relays that are used to switch AC and DC power to the ID interface connector 26.

(e) Interface Circuit: This circuit interfaces the system bus 25 to the remainder of the circuits of this network so that commands and data can be exchanged with microcomputer 2 over the system bus 25.

A standard power supply 19 such as, for example, the LH Research Style MML 47 Power Supply is used to provide D.C. power for the tester circuits and to circuits in the ID, IF necessary. The power supply has seven output voltages +15, −15, +24, +24, −24, +5, +12 VDC.

Transfer relays 20, such as, for example, MS27401-1, switch the AC and DC power to the UUT. AC power is switched under program control. DC power is also under program control but cannot be switched until all UUT supply voltages are within tolerance. If required, a DC fan 21 may be used for cooling.

A block diagram of the optional IEEE-488 interface network 22 is illustrated in Figure 12. It provides the electrical interface and protocol requirements necessary to allow the user to connect an instrument of his own to the tester if the user's instrument is IEEE-488-(1975) bus compatible.

A standard filter 23 may be used to decrease the coupling of noise between the tester and the user's AC input power line. A standard combination circuit breaker on/off switch 24 is provided on the front panel of the tester.

Most of the circuits in the programmable tester are mounted on standard 6 3/4"×12" circuit cards. The cards plug into a standard INTEL SBC 604 or SBC 614 modular backplane and cardcage. These devices serve as a cardcage and provide system bus 25 connections to all of the cards. The tester uses 5 SBC 614 & 1 SBC 604 which provides room for 24 cards. As configured, the programmable tester uses 13 cards leaving 11 spare card positions for future expansion.

The ID interface 26 consists of a well on the horizontal surface of the tester front panel and 3 low insertion force connectors at the bottom of the well. Each connector has 256 contacts. A typical ID would plug into the connectors at the bottom of the well. The ID utilizes 1, 2 or 3 mating connectors depending on the particular signals to which it must connect.

The Interface Device (ID) is a plug in adapter that holds the firmware and provides the electrical/mechanical interface via connectors, wiring, and in addition provides room for locating circuitry for modification of signals if necessary. The ID is not part of the programmable tester but does plug into it.

An ID is prepared in the following manner:

(1) obtain schematic diagram of particular UUT and specifications on UUT connectors;

(2) mount mating connectors for UUT on ID;

(3) obtain tester interface drawings;

(4) analyze UUT to determine test requirements and need for special interface circuits (if required);

(5) design ID providing enough room to hold the non-volatile semiconductor memories that will contain the test program;

(6) write the test program for the UUT in the DOD standard test language ATLAS;

(7) use software station (which contains conversion program) to convert the ATLAS test program into a different form; this new form of the ATLAS test program is called an Interpretive Code (IC) program. (The tester is not required for this step.);

(8) the IC program is now loaded into one or more non-volatile memories. Many types of non-volatile memory can be used. EPROM is preferred but PROM, ROM, can be used. These forms of non-volatile memory are quite suitable for most test programs but in the case of very large test programs the tester can be modified to use bubble, CCD, floppy disc, hard disc or tape memories. The floppy disc, hard disc and tape memories are capable of storing very large programs but are not easily located within the ID;

· (9) the non-volatile memory containing the IC program is now mounted in the ID. If a floppy disc, hard disc or tape are used they probably would not be located in the ID, they would be mounted in a separate enclosure adjacent to the tester.

The operation of the programmable tester illustrated in Figure 1 is as follows. Immediately following turn on of the tester the operation of the tester is under control of microcomputer 2. Turning the tester on causes microcomputer 2 to begin executing an executive program which is stored in a non-volatile memory (located on the microcomputer 2 card). This executive program will cause initialization of the tester hardware and will automatically perform a confidence test of the tester to insure that it is operating properly.

The executive program is written so that the operator will be notified via alphanumeric display 12 if failure within the tester exists and the suspect cards will be listed. If the tester is operating properly the executive program will cause the alphanumeric display 12 to indicate to the operator that he should insert the proper ID (Interface Device) UUT (Unit Under Test) and then actuate the keyboard Load command. Upon actuation of the keyboard Load command, the executive program will cause microcomputer 2 to read the IC form of the test program from the non-volatile memory stored in the ID and load it into the RAM memory on the computer. (The non-volatile memory containing the IC form of the test program is in the memory gap of the microcomputer 2). Upon completion of the load operation

the executive program will cause alphanumeric display 12 to display the name of the UUT using data supplied from the test program.

The executive program will then cause alphanumeric display 12 to prompt the operator to actuate the keyboard 13 GO command. Upon actuation of GO, the ATLAS test program (in IC form) directs the microcomputer 2 to perform the test.

The first step in most tests will be the adjusting of the DC voltages required to power up the UUT. The alphanumeric display 12 prompts the operator to adjust each power supply 16 as required. The alphanumeric display 12 indicates the power supply designation (i.e., #1, #2, #3, #4, #5), the present output voltage of the power supply, and the desired output of the power supply. The power supplies are adjusted manually by the operator via front panel thumb wheel controls 17. The tester itself is essentially automatic in operation except for the adjustment of these power supplies. When all supplies are within tolerance alphanumeric display 12 prompts the operator to actuate keyboard 13 GO. Unless the UUT requires manual intervention the test will now run automatically to completion. The test can either be GO/NO GO or Fault Isolation.

The Atlas test program, now in IC form and having just been read from the permanent memory in the ID into the RAM on microcomputer 2, causes the tester to perform tests in a manner similar to that of the CAT testers marketed by the assignee of the present invention except for the manual adjustment of the power supplies. The IC form test program, when interpreted by the interpreter resident on the iSBC 464 non-volatile memory 1, will cause the stimuli instruments (through the instrument driver programs also resident on the iSBC 464) to be set to the desired output, and the response instruments to be set to the desired output, and the response instruments to be set to the desired range, and the switching circuit to connect the instruments as required.

Instruments of the type shown in Figs. 6, 7 are listed in: Hewlett Packard Measurement/Computation Electronic Instruments and Systems Catalog for 1980 on the page indicated Counter Timer (C/T) 5328A Page 310 and Digital Multimeter (DMM) 3438A, Page 62. Both instruments would have to be repackaged for use in the present invention. In addition, an interface circuit, shown as part of each instrument, would also be required to convert the signals on the microprocessor type bus to signals compatible with the HP—IB bus. The design of the interface circuit is within the skill of a person having ordinary skill in the art. HP—IB is a bus standard established by the Hewlett Packard Corp.

It is clear that the above description of the preferred embodiment in no way limits the scope of the present invention which is defined by the following claims.

## Claims

1. Programmable test apparatus comprising:

a) connecting means (26) for receiving interface means configured to adapt a unit under test having digital, analog, or hybrid electronics to said test apparatus;

b) microprocessor type system bus means (25);

c) microcomputer means (2) operatively connected to said microprocessor type system bus means and including means for executing a test program for testing the operation of said unit under test;

d) memory means (1) associated with said microcomputer means operatively connected to said microprocessor type system bus means, said memory means including non-volatile memory storing an interpreter program;

e) microprocessor control means (3) operatively connected to said microprocessor type system bus means and including means for loading said test program into said microcomputer memory means, said loading means loading said test program in a compact interpretive code format from non-volatile memory in said interface means;

f) programmable stimulus generating means (4, 5, 6) operatively connected via said microprocessor type system bus means to said microprocessor control means and said microcomputer means;

g) programmable response measuring means (7, 8) operatively connected via said microprocessor type system bus means to said microprocessor control means and said microcomputer means;

h) programmable switching means (9, 10, 11) for selectively connecting said stimulus generating means and said response measuring means via said interface means to said unit under test, said switching means responsive to and operatively connected via a switching control bus means to said microprocessor control means;

i) alphanumeric display means (12) operatively connected via a first dedicated bus to said microprocessor control means;

j) keyboard means (13) operatively connected via a second dedicated bus to said microprocessor control means and including means for initiating execution of said test program, and

k) said interpreter program interpreting said interpretive code format test program into microprocessor instructions for carrying out tests determined by said test program.

2. Programmable test apparatus as recited in claim 1, wherein said microprocessor control means also includes means for loading said compact interpretive code format test program directly from an external software station.

3. Programmable test apparatus as recited in claim 1 or 2, including programmable digital signal generating means operatively connected via said microprocessor type system bus means to said microprocessor control means and said microcomputer means and including means for effecting data communication directly via said interface means with said unit under test.

4. Programmable test apparatus as recited in claim 1 or 2, including an IEEE-488 compatible interface means (22) for effecting connection of an external instrument to said microprocessor type system bus means.

5. Programmable test apparatus as recited in claim 2 wherein said interface means includes means for effecting data communication with external memory means.

6. Programmable test apparatus as recited in claim 1 or claim 2 further including separate software station means for converting a test program written in a high level language into said compact interpretive code format to be loaded directly to said microcomputer means or to said interface means.

7. Programmable test apparatus as recited in claim 6 wherein said keyboard means includes means for modifying said test program.

8. Programmable test apparatus as recited in claim 7 wherein the high level language is ATLAS.

9. Programmable test apparatus as recited in claim 8 wherein said microprocessor control means includes means for effecting data communication with an external software station, said software station including means for converting the ATLAS language test program to interpretive code format.

10. Programmable test apparatus as recited in claim 9 wherein said test interface means includes means for effecting data communication with external memory means.

## Patentansprüche

1. Programmierbares Prüfgerät mit

a) Verbindungsmitteln (26) zur Aufnahme einer Interface-Einrichtung für die Anpassung einer zu prüfenden Einheit mit digitalen, analogen oder hybriden elektronischen Schaltungen an das Prüfgerät;

b) einem Mikroprozessor-System-Bus (25);

c) einem mit dem Mikroprozessor-System-Bus wirkungsmäßig verbundenen Mikrocomputer (2) mit Mittel zur Ausführung eines Prüfprogramms für die Funktionsprüfung der zu prüfenden Einheit;

d) einer dem Mikrocomputer zugeordneten Speichereinrichtung (1), die wirkungsmäßig mit dem Mikroprozessor-System-Bus verbunden ist, wobei die Speichereinrichtung einen nichtflüchtigen Speicher aufweist, der ein Zuordnungsprogramm speichert;

e) einer Mikroprozessor-Steuereinrichtung (3), die mit dem Mikroprozessor-System-Bus wirkungsmäßig verbunden ist und Mittel zum Laden des Prüfprogramms in die Speichereinrichtung des Mikrocomputers aufweist, wobei die Lademittel das Prüfprogramm in einem kompakten Zuordnungskodeformat aus dem nichtflüchtigen Speicher in die Interface-Einrichtung laden;

f) einer programmierbaren Generatoreinrichtung (4, 5, 6) zur Erzeugung von Anreizen, die über den Mikroprozessor-System-Bus mit der Mikroprozessor-Steuereinrichtung und dem Mikrocomputer wirkungsmäßig verbunden ist;

g) einer über den Mikroprozessor-System-Bus mit der Mikroprozessor-Steuereinrichtung (3) und dem Mikrocomputer wirkungsmäßig verbundenen programmierbaren Meßeinrichtung (7, 8) für die Antwortmessung;

h) programmierbaren Schaltmittel (9, 10, 11) für die über die Interface-Einrichtung erfolgende selective Verbindung der Generatoreinrichtung zur Erzeugung von Anreizen und der Meßeinrichtung für die Antwortmessung mit der zu prüfenden Einheit, wobei diese Schaltmittel auf die Mikroprozessor-Steuereinrichtung ansprechen und über einen Schalter-Steuer-Bus wirkungsmäßig mit dieser verbunden sind;

i) alphanumerischen Anzeigemitteln (12), die über einen ersten speziell zugeordneten Bus wirkungsmäßig mit der Mikroprozessor-Steuereinrichtung verbunden sind;

j) einer Tastaturanordnung (13), die wirkungsmäßig über einen zweiten speziell zugeordneten Bus mit der Mikroprozessor-Steuereinrichtung verbunden ist und Mittel enthält, die die Ausführung des Prüfprogramms einleiten, und

k) wobei das Zuordnungsprogramm das im Zuordnungskodeformat vorliegende Prüfprogramm im Mikriprozessor-Befehle umordnet, um durch das Prüfprogramm bestimmte Prüfungen durchzuführen.

2. Programmierbares Prüfgerät nach Anspruch 1, bei dem die Mikroprozessor-Steuereinrichtung ferner Mittel enthält, die das Prüfprogramm im kompakten Zuordnungskodeformat direkt von einer externen Software-Station laden.

3. Programmierbares Prüfgerät nach Anspruch 1 oder 2 mit einer programmierbaren digitalen Signalgeneratoreinrichtung, die über den Mikroprozessor-System-Bus wirkungsmäßig mit der Mikroprozessor-Steuereinrichtung und dem Mikrocomputer verbunden ist und Mittel enthält, um über die Interface-Einrichtung eine direkte Datenkommunikation mit der zu prüfenden Einheit zu bewirken.

4. Programmierbares Prüfgerät nach Anspruch 1 oder 2 mit einer IEEE-488-kompatiblen Interface-Einrichtung (22) zur Verbindung eines externen Geräts mit dem Mikroprozessor-System-Bus.

5. Programmierbares Prüfgerät nach Anspruch 2, bei dem die Interface-Einrichtung Mittel für die Datenkommunikation mit einer externen Speichereinrichtung enthält.

6. Programmierbares Prüfgerät nach Anspruch 1 oder 2, bei dem ferner eine separate Software-Station vorgesehen ist zum Umsetzen eines in einer höheren Programmiersprache geschriebenen Prüfprogramms in ein kompaktes Zuordnungskodeformat, das direkt in den Mikrocomputer oder die Interface-Einrichtung zu laden ist.

7. Programmierbares Prüfgerät nach Anspruch 6, bei dem die Tastaturanordnung Mittel zum Ändern des Prüfprogramms aufweist.

8. Programmierbares Prüfgerät nach Anspruch 7, bei dem die höhere Programmiersprache ATLAS ist.

9. Programmierbares Prüfgerät nach Anspruch 8, bei dem die Mikroprozessor-Steuereinrichtung Mittel zur Durchführung einer Datenkommunikation mit einer externen Software-Station aufweist, wobei diese Software-Station Mittel zum Umwandeln des in ATLAS vorliegenden Prüfprogramms in das Zuordnungskodeformat enthalten.

10. Programmierbares Prüfgerät nach Anspruch 9, bei dem die Prüf-Interface-Einrichtung Mittel für die Datenkommunikation mit einer externen Speichereinrichtung aufweist.

**Revendications**

1. Appareil à tester programmable comprenant:

a) des moyens de liaison (26) pour recevoir une interface configurée pour adapter une unité sous test présentant un dispositif électronique numérique, analogique ou hybride audit appareil à tester;

b) un bus de système de type microprocesseur (25);

c) un microordinateur (2), connecté de façon fonctionnelle audit bus de système de type microprocesseur et comprenant des moyens pour exécuter un programme de test pour tester le fonctionnement de ladite unité sous test;

d) une mémoire (1) associée audit microordinateur connecté de façon fonctionnelle audit bus de système de type microprocesseur, ladite mémoire comprenant une mémoire non-volatile stockant un programme interprétatif;

e) des moyens (3) pour la commande du microprocesseur, connectés de façon fonctionnelle audit bus de système de type microprocesseur et comprenant des moyens pour charger ledit programme de test dans ladite mémoire du microordinateur, lesdits moyens de chargement chargeant ledit programme de test dans un format de code interprétatif compact à partir de la mémoire non-volatile dans ladite interface;

f) des moyens générateurs de stimuli (4, 5, 6), programmables connectés de façon fonctionnelle, par l'intermédiaire dudit bus de système de type microprocesseur, auxdits moyens de commande du microprocesseur et audit microordinateur;

g) des moyens de mesure de réponse (7, 8), programmables, connectés de façon fonctionnelle, par l'intermédiaire dudit bus de système de type microprocesseur, auxdits moyens de commande du microprocesseur et audit microordinateur;

h) des moyens de commutation (9, 10, 11), programmables, pour connecter de façon sélective lesdits moyens générateurs de stimuli et lesdits moyens de mesure de réponse, par l'intermédiaire de ladite interface, à ladite unité sous test, lesdits moyens de commutation étant sensibles à et connectés de façon fonctionnelle, par l'intermédiaire d'un bus de commande de commutation, auxdits moyens de commande du microprocesseur;

i) des moyens d'affichage alphanumériques (12) connectés de façon fonctionnelle, par l'intermédiaire d'un premier bus dédié, auxdits moyens de commande du microprocesseur;

j) un clavier (13), connecté de façon fonctionnelle, par l'intermédiaire d'un second bus dédié, auxdits moyens de commande du microprocesseur, et comprenant des moyens pour initialiser l'exécution dudit programme de test; et

k) ledit programme interprétatif interprétant ledit programme de test en format de code interprétatif en instructions de microprocesseur pour effectuer des tests déterminés par ledit programme de test.

2. Appareil à tester programmable selon la revendication 1, dans lequel lesdits moyens de commande du microprocesseur comprennent également des moyens pour charger ledit programme de test en format de code interprétatif compact, directement à partir d'une station de logiciel externe.

3. Appareil à tester programmable selon l'une des revendications 1 et 2, comprenant des moyens générateurs de signaux numériques programmables, connectés de façon fonctionnelle, par l'intermédiaire dudit bus de système de type microprocesseur, auxdits moyens de commande du microprocesseur et audit micorordinateur, et comprenant des moyens pour effectuer une communication de données directement par l'intermédiaire de ladite interface avec ladite unité sous test.

4. Appareil à tester programmable selon l'une des revendications 1 et 2, comprenant une interface compatible IEEE-488 (22) pour effectuer la connexion d'un instrument externe audit bus de système de type microprocesseur.

5. Appareil à tester programmable selon la revendication 2, dans lequel la dite interface comprend des moyens pour effectuer une communication de données avec une mémoire externe.

6. Appareil à tester programmable selon l'une des revendication 1 et 2, comprenant en outre une station de logiciel séparée pour convertir un programme de test écrit dans un langage évolué en ledit format de code interprétatif compact devant être chargé directement dans ledit microordinateur ou dans ladite interface.

7. Appareil à tester programmable selon la revendication 6, dans lequel ledit clavier comprend des moyens pour modifier ledit programme de test.

8. Appareil à tester programmable selon la revendication 7, dans lequel le langage évolué est ATLAS.

9. Appareil à tester programmable selon la revendication 8, dans lequel lesdits moyens de commande du microprocesseur comprennent des moyens pour effectuer une communication de données avec une station de logiciel externe, ladite station de logiciel comprenant des moyens pour convertir le programme de test en langage ATLAS en format de code interprétatif.

10. Appareil à tester programmable selon la revendication 9, dans lequel ladite interface de test comprend des moyens pour effectuer une communication de données avec une mémoire externe.

FIG. I

# FIG. 1'

EP 0 157 028 B1

GAC
IEEE-498 INTERFACE CARD
22

TO USER SUPPLIED INSTRUMENT

MULTIBUS

No.2 HI LO
No.3 HI LO

USER RELAYS    24 WIRES IN THIS GROUP FROM USER RELAYS

2
2
24

TO SOFTWARE STATION

MULTIBUS    GAC DC POWER

MULTIBUS    3    CONTROL CARD

TEST PROGRAM    50

12    ALPHA/NUMERIC DISPLAY
32 CHAR DE/232
DISPLAY P.S. DE/285

13    KEYPAD
BURR BROWN
MT-10

DC POWER

14    RESET

P.B. ON FRONT PANEL

GAC DC POWER

MULTIBUS    15    DIGITAL SIGNAL CARD    32 DIGITAL SIGNALS FOR UUT    32

5 FRONT PANEL CONTROLS
TO ADJUST POWER SUPPLY

16    5 P.S. FOR UUT

19    DC POWER SOURCE

DC P.S. FOR T/S AND USE IN IO
±15 ±24 +5 +24 +2

DC POWER FOR ID    12

REAR PANEL

GAC
MULTIBUS    18    POWER SUPPLY CONTROL ASSY.

-12V DC POWER SOURCE

DC POWER

21    DC FAN    DC POWER

USER P.S.

GAC
TRANSFER RELAYS
20    DC POWER

AC INPUT POWER
115V AC
50 TO 440 Hz

FILTER    23    FRONT PANEL CB    24

SWITCHED AC IOC POWER TO UUT

2

FIG.2A

FIG.2B

FIG.3

FIG.4

FIG.5

FIG.6

FIG.7

FIG.8

FIG.9

9

TO ID
INTERFACE

DRIVERS/
RECEIVERS

DRIVERS/
RECEIVERS

DRIVERS/
RECEIVERS

DRIVERS/
RECEIVERS

RAM

RAM

RAM

RAM

MEMORY
AND I/O
CONTROL

INTERFACE
CIRCUIT

MULTIBUS

FIG.IO

FIG.11

FIG.12